# NEW EUROPEAN PATENT SPECIFICATION

(11) **EP 0 451 990 B2**
(45) Date of publication and mention of the opposition decision: **21.03.2007**
(45) Mention of the grant of the patent: 19.06.1996
(21) Application number: 91302686.0
(22) Date of filing: 27.03.1991
(51) Int. Cl.: H03J 7/18, H03J 1/00

(54) **Frequency selecting method in RDS receiver**
Verfahren zum Wählen einer Frequenz für einen RDS-Empfänger
Procédé de sélection d'une fréquence pour un récepteur RDS

(30) Priority: 27.03.1990 JP 7847790; 30.03.1990 JP 8573490
(43) Date of publication of application: 16.10.1991
(60) Divisional application: 95201275.5
(73) Proprietor: PIONEER ELECTRONIC CORPORATION, Meguro-ku Tokyo-to (JP)
(72) Inventor: Kasa, Koichi, c/o Pioneer Electronic Corp., Kawagoe-shi, Saitama (JP); Miyake, Takashi, c/o Pioneer Electronic Corp., Kawagoe-shi, Saitama (JP); Fuse, Junichi, c/o Pioneer Electronic Corp., Kawagoe-shi, Saitama (JP); Nishida, Junichi, c/o Pioneer Electronic Corp., Kawagoe-shi, Saitama (JP); Hirano, Sachiyo, c/o Pioneer Elec. Corp., Ohaza Yamada, Kawagoe-shi, Saitama (JP); Hatori, Tomoyasu, c/o Pioneer Elec. Corp., Ohaza Yamada, Kawagoe-shi, Saitama (JP); Miyano, Koichi, c/o Pioneer Elec. Corp., Ohaza Yamada, Kawagoe-shi, Saitama (JP); Shishido, Osamu, c/o Pioneer Elec. Corp., Ohaza Yamada, Kawagoe-shi, Saitama (JP); Kobayashi, Hideaki, c/o Pioneer Elec. Corp., Ohaza Yamada, Kawagoe-shi, Saitama (JP); Matsumoto, Isao, c/o Pioneer Elec. Corp., Ohaza Yamada, Kawagoe-shi, Saitama (JP); Nagai, Keigo, c/o Pioneer Elec. Corp., Ohaza Yamada, Kawagoe-shi, Saitama (JP)
(74) Representative: Tomlinson, Kerry John

(56) References cited:
- EP-A- 0 275 527
- DE-A- 3 832 455
- DE-C- 3 439 941
- PATENT ABSTRACTS OF JAPAN vol. 13, no. 323 (E-791)21 July 1989 & JP-A-1 090 609
- PATENT ABSTRACTS OF JAPAN vol. 12, no. 395 (E-671)20 October 1988 & JP-A-63 136 830
- Funkschau 25 / 1986: "Radio-Daten-System: Infosystem mit Lückenfüllern", S. 28 - 30
- "RDS-Engineering Concept", Veröffentlichung der BBC aus dem Jahre 1989
- Tech. 3244-E -"specifications of the radio data system for VHF/FM sound broadcasting", European Broadcasting Union, März 1984
- Deckblatt der Kundendienstschrift zum Autoradio Montreux RDR 49, Dezember 1988
- Auszug aus dem RDS-Programm des Autoradiogeräts Montreux RDR 49, Oktober 1988

## Description

### BACKGROUND OF THE INVENTION

The present invention relates to a receiving frequency selecting method in a receiver for a radio data system (hereinafter, referred to as an RDS receiver).

There has been known a radio data system (RDS) in which upon program broadcasting of a general broadcasting station, broadcast-related information such as information regarding the content of the program and the like is multiplex modulated as data for the transmission. On the reception side, the transmitted data is demodulated and a desired program content can be selected on the basis of the demodulated data, thereby enabling the broadcasting service of the program to be provided to a radio listener.

In the radio data system, a signal of 57 kHz as a third order harmonic of a stereo pilot signal of 19 kHz is used as a subcarrier in a band out of the frequency band of a frequency modulated wave. The subcarrier is amplitude modulated by a data signal which has been filtered and biphase encoded and which indicates information regarding the broadcast such as program content or the like. The amplitude modulated subcarrier is used as a radio data signal and is frequency modulated into the main carrier and is broadcast. The standard for this broadcasting method has been proposed by the European Broadcasting Union (EBU).

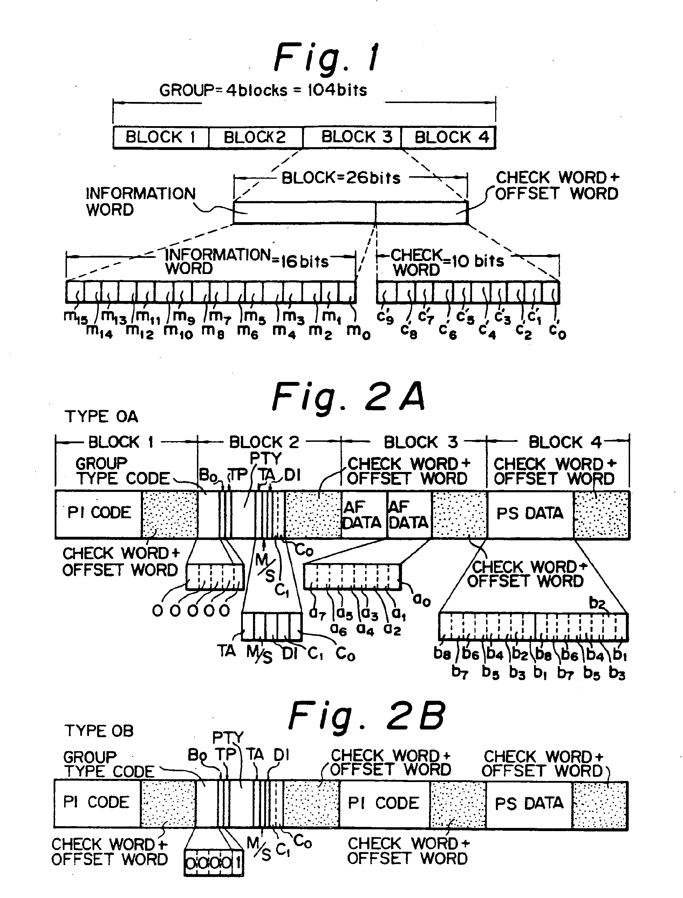

As will be obviously understood from Fig. 1 showing a base band coding structure of a radio data signal, the radio data signal is repeatedly transmitted by a multiplex transmission, in group unitseach comprising 104 bits. One group is constituted by four blocks each consisting of 26 bits. Each block comprises an information word of 16 bits and a check word of 10 bits. The groups are classified into sixteen types 0 to 15 in accordance with the content by using four bits. Two versions A and B are defined foreach of the types (0 to 15).

Figs. 2A and 2B respectively show the format of the groups type 0A and type 0B. In the type 0A group, program ID data (hereinafter, referred to as PI data) of 16 bits comprising a country code, an area code, and a program code is arranged in the block 1, various codes comprising a group type code, a version code (B₀), a traffic information broadcasting station ID (TP) code, a program content ID (PTY) code, and the like are arranged in the block 2, station frequency data (hereinafter, abbreviated to AF data) of network stations which are broadcasting the same program is arranged in the block 3, and broadcasting station name data (hereinafter, abbreviated to PS data) is arranged in the block 4. On the other hand, in the type 0B group, the respective data are arranged in the blocks 1, 2, and 4 in a manner similar to the type 0A group except that only the content in the block 3 differs from that in the case of the type 0A group and the PI data is arranged in the block 3. That is, the AF data of the network stationsis transmitted by only the type 0A group and the PS data is transmitted by both of the groups of the types 0A and 0B.

As mentioned above, the AF data of the network stations broadcasting the same program as that of the broadcasting station which is currently being received is also included in the radio data signal of the type 0A group. Therefore, upon reception, the AF data and the PI data which have been obtained by the demodulation are taken and stored as an AF list. For instance, if a receiving intensity of the broadcasting station which is currently being received deteriorates due to a disturbance such as a multi-path interference or the like, another station in the same network station group is selected on the basis of the AF list which has previously been stored. Further, a check is made to see if the program received by the AF list is correct or not by what is called a PI check to compare and check for coincidence of the PI data. By what is called a network following function as mentioned above, the same program can be always listened to in a good receiving state without being influenced by the disturbances.

In the network following function, when the existence of the new same network station has been detected on the basis of the AF list, hitherto, a timer of a predetermined time is set and the PI data obtained from the broadcasting wave of such a station is taken and, after the time-up of the timer, the PI data is checked. In the case where the PI check is performed after the elapse of a predetermined time after the existence of the same network station had been detected as mentioned above, it is possible to cope with various cases of field conditions. However, even in the stable receiving state, a muting process is necessarily executed for the predetermined time. This means that a time period in which the user is disturbed becomes long by an amount corresponding to the period of such a muting process.

In the network following operation, in the case where the existence of a same network station in a good receiving state cannot be detected from the same network station group, hitherto, the receiving station is returned to the broadcasting station (original receiving station) which was being received at first (for instance, reference is directed to Japanese Patent Application Laid Open No. 1-151319). However, if the receiving is merely returned to the original receiving station, the receiving state with a low receiving signal intensity will forcibly be set. In the case where the listener wishes to subsequently listen to the broadcasting of the same program in a good receiving state, a broadcasting station which broadcasts the same program must be searched by a manual tuning (station selection) operation.

It is, therefore, an object of the invention to provide a receiving frequency selecting method in an RDS receiver, in which by enabling a PI check to be performed in a short time, a disturbance associated with a muting process upon PI check is reduced.

Another object of the invention is to provide a receiving frequency selecting method in an RDS receiver, in which even in the case where the existence of a same network station is not detected through the network following operation, a broadcasting station of the same program can be automatically searched.

According to the present invention, there is provided a receiving frequency selecting method as defined in claim 1.

In the receiving frequency selecting method according to one aspect of the invention, the PI data of the currently received station is held in response to a command and, when the existence of a received station based on the AF list is detected and the same PI data is taken in a plural number of times as PI data which is derived from the broadcasting wave of the received station, the PI check is executed even if a predetermined time has not elapsed from a time point when the existence of the received station is detected.

According to one aspect of the invention, a further step is provided for detecting when the existence of the same network station has not been detected in the second step, whether or not a received station whose reception signal level is equal to or higher than a set level and in which the PI data obtained from the received broadcasting wave of said received station coincides with the PI data held in the first step exists by sweeping the receiving frequency in a reception band, and setting the frequency of said received station as a new receiving frequency if the existence of said received station is detected.

In the receiving frequency selecting method according to the second aspect of the invention, the PI data of the originally received station is previously held, and in the case where the existence of the same network station cannot be detected by the network following function, when the existence of a received station whose reception signal level is equal to or higher than a set level and in which the received PI data coincides with the holding PI data is detected while executing a frequency sweeping operation, the frequency of such a received station is set as a new receiving frequency.

Embodiments of the invention will now be described by way of example only and with reference to the accompanying drawings.

### DESCRIPTION OF THE DRAWINGS

Fig. 1 is a diagram showing a base band coding structure of radio data;
Figs. 2A and 2B are diagrams showing the format of group types 0A and 0B;
Fig. 3 is a block diagram showing a fundamental construction of an RDS receiver to which a receiving frequency selecting method according to the invention is applied; and
Figs.4, and 5A and 5B (when combined),are flowcharts showing examples of processing procedures in the network follow operation that is the receiving frequency selecting method according to the invention.

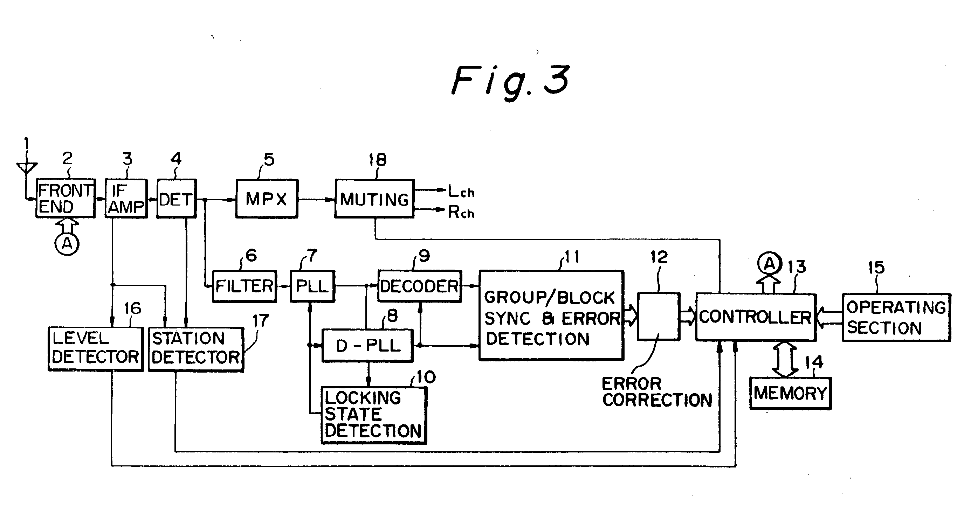

Fig. 3 is a block diagram showing an outline of a fundamental construction of an RDS receiver to which a receiving frequency selecting method according to the invention is applied. In the diagram, an FM multiplexed broadcasting wave received by an antenna 1 is supplied to a front-end 2, by which a desired station is selected and the broadcasting wave of the selected station is converted into an intermediate frequency (IF). After that, the IF signal is supplied to an FM detector 4 through an IF amplifier 3. The front-end 2 uses, for instance, a PLL synthesizer system using a PLL circuit including a programmable frequency divider and executes a station selecting operation by a method whereby a frequency dividing ratio of the programmable frequency divider is controlled by a controller 13, which will be explained hereinlater. A detection output of the FM detector 4 is supplied to an MPX (multiplex) demodulator 5 and is separated into audio signals of the L (left) and R (right) channels in the case of the stereophonic broadcasting. The audio signals are supplied to a muting circuit 18, so that reproduction audio outputs are derived. The muting circuit 18 is on/off controlled by the controller 13.

The detection output of the FM detector 4 is transmitted through a filter 6, so that a subcarrier of 57 kHz which has been amplitude modulated by a biphase encoded data signal, that is, a radio data signal is extracted and is demodulated by a PLL circuit 7. The demodulation output is supplied to a digital (D) PLL circuit 8 and a decoder 9. The D-PLL circuit 8 produces a clock for data demodulation on the basis of the demodulation output of the PLL circuit 7. In the decoder 9, the biphase encoded data signal as a demodulation output of the PLL circuit 7 is decoded synchronously with the clock generated from the D-PLL circuit 8. A locking state detecting circuit 10 detects locking/unlocking states of the D-PLL circuit 8. Locking ranges of the PLL circuit 7 and D-PLL circuit 8 are switched by a detection output of the locking state detecting circuit 10.

As shown in Fig. 1, output data of the decoder 9 has a group unit of 104 bits comprising four blocks each consisting of 26 bits and is sequentially supplied to a group/block sync & error detecting circuit 11. In the detecting circuit 11, synchronization of the group and the block is attained on the basis of an offset word of 10 bits assigned to each check word of 10 bits of each block. An error of an information word of 16 bits is detected on the basis of the check word. The error detected data is error corrected by an error correction circuit 12 at the next stage and, thereafter, the corrected data is supplied to the controller 13.

The controller 13 is constituted by a microcomputer. The code information of each block in the radio data which is sequentially supplied on a group unit basis, that is, the radio data information such as PI data, AF data, PS data, and the like regarding the program content of the broadcasting station which is currently being received is taken in and stored into a memory 14. The controller 13 executes the network following function by controlling the frequency dividing ratio of the programmable frequency divider (not shown) of the PLL circuit constituting a part of the front-end 2 on the basis of a station selecting command from an operating section 15.

A level detecting circuit 16 to detect a reception signal level (electric field intensity) on the basis of an IF signal level in the IF amplifier 3 is also provided. There is further provided a station detecting circuit 17 for detecting a receiving station in the case where the IF signal level in the IF amplifier 3 is equal to or higher than a predetermined level and where a detection output having what are called S-curve characteristics in the FM detector 4 lies within a predetermined level range and for generating a station detection signal. The reception signal level detected by the level detecting circuit 16 and the station detection signal which is generated from the station detecting circuit 17 are supplied to the controller 13.

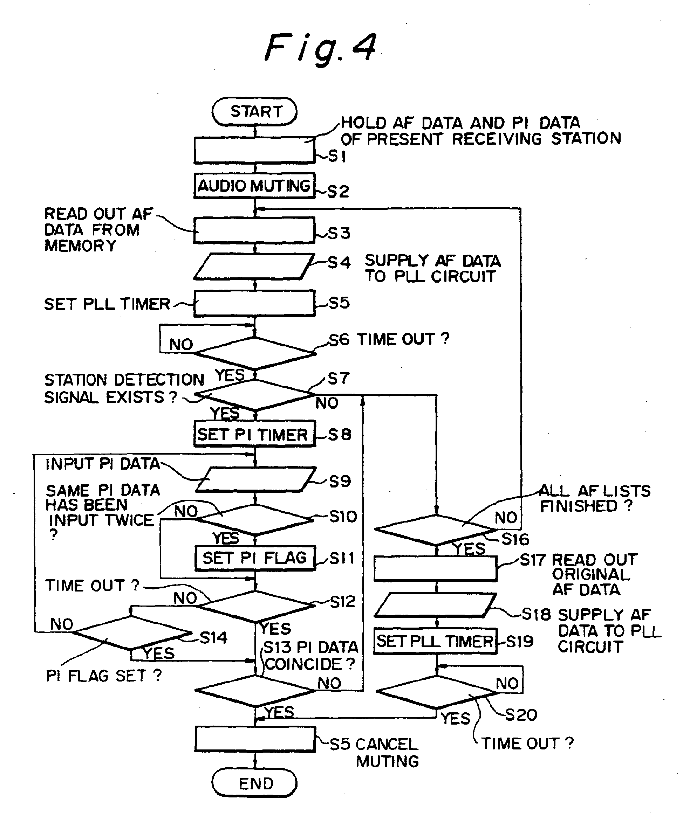

A processing procedure in the network following function which is executed by the processor of the controller 13 will now be described in accordance with a flowchart of Fig. 4.

It is assumed that the above processing routine is called for execution by a switching command which is generated when a receiving intensity of the broadcasting station which is currently being received has deteriorated due to a disturbance such as a multi-path interference or the like. On the other hand, it is assumed that the AF data obtained by demodulating the received broadcasting wave has been taken in and an AF list of the same network stations as the broadcasting station which is currently being received has already been made and stored in the memory 14.

The processor first fetches the AF data and PI data of the broadcasting wave which is currently being received and stores and holds into predetermined areas in the memory 14 (step S1). The muting circuit 18 is turned on to execute an audio muting process (step S2). Subsequently, one AF data in the list is read out of the memory 14 on the basis of the AF list stored in the memory 14 (step S3). After that, the read AF data is supplied to a PLL circuit (not shown) in the front-end 2 (step S4). Further, a PLL timer of a time necessary to lock the PLL circuit is set (step S5). The AF data supplied to the PLL circuit is set into the programmable frequency divider in the PLL circuit. For a period of time until the PLL timer times up, the receiving frequency is changed from the current receiving frequency to a frequency of another network station.

After the PLL timer has timed out (step S6), the processor checks that a station is being received by monitoring a station detection signal output from the station detecting circuit 17 (step S7). If the existence of a received station is detected, a PI timer of a predetermined time is set (step S8). After that, the PI data of the receiving station is taken in (step S9). The processor subsequently checks to see if the same PI data has been taken in a plurality of number of times (for example, two times) or not (step S10). If the same PI data has been taken in a plurality of number of times, a PI flag is set (step S11). A check is then made to see if the PI timer has timed up or not (step S12). If it is determined in step S10 that the same PI data is not taken a plurality of number of times, the processing routine directly advances to step S12.

If it is determined in step S12 that the PI timer has timed out, the processor executes the PI check to see if the PI data taken currently coincides with the PI data held in step S1 or not (step S13). If it is detected that the PI timer has not yet timed out, a check is made to see if the PI flag has been set or not (in other words, to see if the same PI data has been taken in a plurality of number of times in step S10 or not) (step S14). If the PI flag has been set, step S13 follows. If the PI flag is not set, the processing routine is returned to step S9.

If it is determined that both of the PI data coincide as a result of the PI check in step S13, the processor turns off the muting circuit 18, thereby canceling the audio muting (step S15). Thus, the frequency of the station presently being received is set as a new receiving frequency and the same PI station in the same network station group has been selected.

If the absence of the received station is determined in step S7 or if it is decided in step S13 that the PI data differ, the processor discriminates whether the checks regarding the existence of the received station and the PI checks have been finished with respect to all of the AF lists or not (step S16). If all of the above checks are not completed, the processing routine is returned to step S3 and the foregoing processes are repeated. If the checks for all of the AF lists have been finished, the processor reads out the original AF data held in step S1 (step S17) and subsequently supplies the read AF data to the PLL circuit (step S18). Further, the PLL timer is set (step S19). After the PLL timer has timed up (step S20), the processing routine advances to step S15 and the audio muting is canceled. Thus, the receiving frequency has been returned to the frequency of the original receiving station.

In the above embodiment, only the existence of the received station has been detected prior to the PI check (step S7). However, it is also possible to arrange that after the detection of the existence of the received station, the reception signal level of the received station is taken from the level detecting circuit 16 and it is detected that the reception signal level is equal to or higher than a set level and, thereafter, the processing routine advances to step S8.

As described above, in the above embodiment of the receiving frequency selecting method according to the invention, the PI data of the presently received station is held in response to a command, the existence of the received station based on the AF list is detected, and when the same PI data has been taken a plurality of number of times as PI data which is derived from the broadcasting wave of the received station, the PI check is executed even if a predetermined time doesn't elapse from a time point of the detection of the existence of the received station, so that the PI check can be performed in a time shorter than that of the conventional method. Therefore, a feeling of disturbance associated with the muting process upon PI check can be reduced. On the other hand, in a case where the muting process were not executed during the PI check, an interruption time of another program can be reduced.

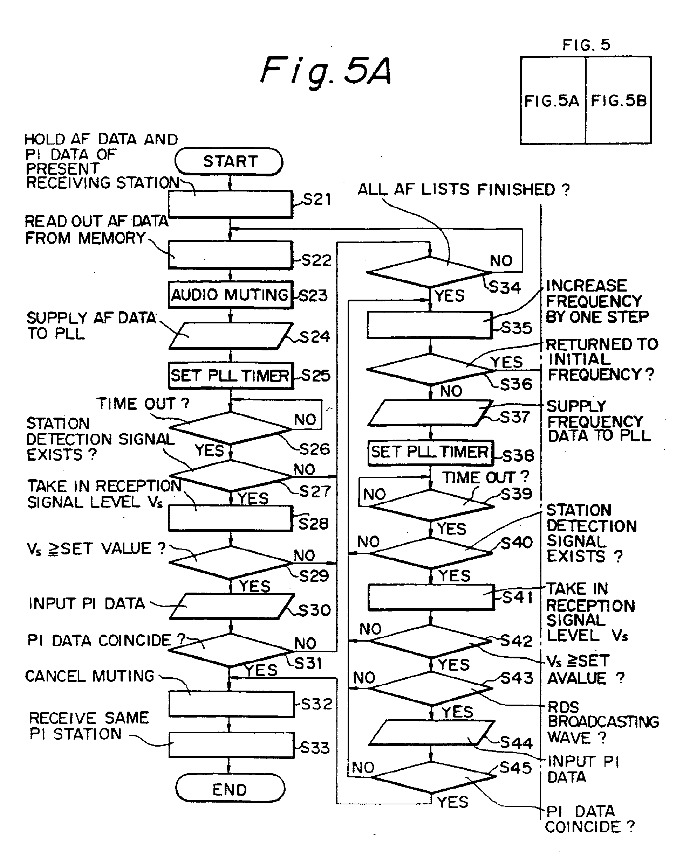

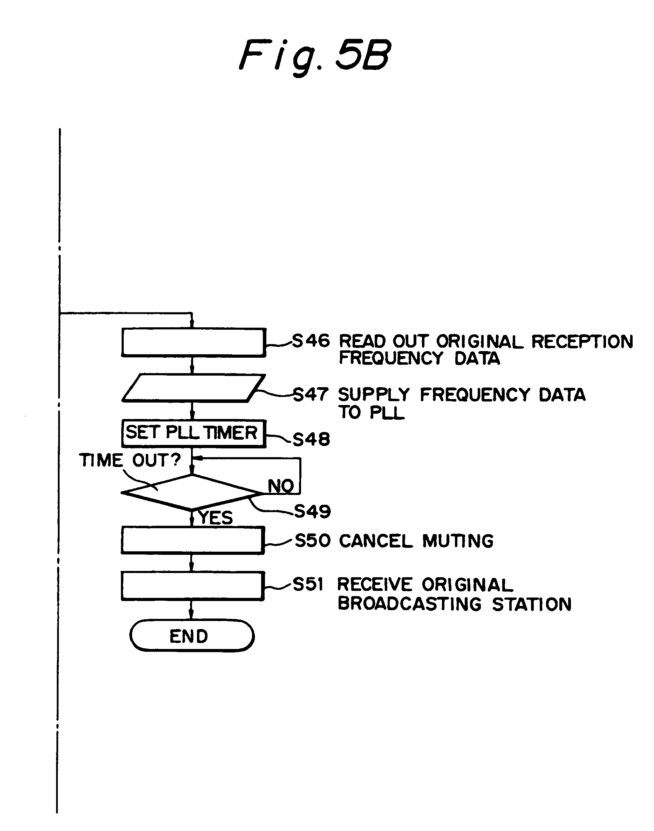

The second embodiment of a receiving frequency selecting method according to the invention will now be described with reference to the flowchart of Figs. 5A and 5B.

In a manner similar to the case of the first embodiment, it is assumed that the processing routine is accessed and executed by a switching command which is generated when the receiving intensity of the broadcasting station which is currently being received deteriorates because of a disturbance such as a multiple-path interference or the like. It is also assumed that the AF data which is derived by demodulating the received broadcasting wave has been taken and the AF list of the same network stations of the broadcasting station which is currently being received has already been made and stored in the memory 14.

The processor first fetches the AF data and PI data of the broadcasting wave which is currently being received and stores and holds into predetermined areas in the memory 14 (step S21). One AF data in the list is read out of the memory 14 on the basis of the AF list stored in the memory 14 (step S22). Subsequently, the muting circuit 18 is turned on, thereby executing the audio muting (step S23). After that, the read AF data is supplied to the PLL circuit (not shown) in the front-end 2 (step S24). The PLL timer of a time necessary to lock the PLL circuit is set (step S25). The AF data supplied to the PLL circuit is set into the programmable frequency divider in the PLL circuit. For a period of time until the PLL timer has timed out, the receiving frequency changes from the current receiving frequency to a frequency of another same network station.

After the PLL timer has timed out (step S26), the processor discriminates whether a received station exists or not by monitoring an output of the station detection signal from the station detecting circuit 17 (step S27). If a received station exists, a reception signal level Vₛ of the same network station which is currently being received is taken from the level detecting circuit 16 (step S28). A check is made to see if the reception signal level Vₛ is equal to or higher than a predetermined set level Vₜₕ or not (step S29). If the reception signal level Vₛ is equal to or higher than the set level Vₜₕ, the processor takes in the PI data of such a received station (step S30). Subsequently, a check is made to see if the taken PI data coincides with the PI data held in step S1 or not (step S31). If they coincide, the muting circuit 18 is turned off, thereby canceling the audio muting (step S32). The frequency of the presently received station is set as a new receiving frequency (step S33). Thus, the same PI station in the same network station group can be received.

If it is determined in step S7 that a received station doesn't exist or if it is decided in step S29 that the reception signal level Vₛ is less than the set level Vₜₕ or if it is determined in step S31 that those PI data are not coincident, the processor checks the existence of a received station, the reception signal level Vₛ, and the completion of the comparison about the coincidence of the PI data for all of the AF lists (step S34). If the above checking processes are not finished yet, the processing routine is returned to step S22 and the above processes are repeated. If the checks for all of the AF lists have been finished and a station which can be received doesn't exist, the frequency is returned to the original receiving frequency.

The ordinary network following function has been described above. In the invention, the functions, which will be explained hereinlater, are further added.

If it is determined in step S34 that the checks for all of the AF lists have been finished, the processor increases the receiving frequency by only one step (a predetermined frequency) (step S35). A check is then made to see if the increased set frequency has been returned to the initial frequency or not (step S36). (The frequency returns to the lowest frequency in the band after the highest frequency is reached.) If it is not returned to the initial frequency, the frequency data is supplied to the PLL circuit (step S37) and the PLL timer is also set (step S38). After the PLL timer has timed out (step S39), the processor discriminates whether a received station exists or not by monitoring the output of the station detection signal from the station detecting circuit 17 (step S40). If a received station exists, the reception signal level Vₛ of the received station is taken (step S41). A check is made to see if the reception signal level Vₛ is equal to or higher than the predetermined set level Vₜₕ or not (step S42). If it is equal to or higher than the set level Vₜₕ, a check is made to see if the reception broadcasting wave is an RDS broadcasting wave or not (step S43). Such a discrimination about the RDS broadcasting wave can be made by checking whether various kinds of data can be derived from the error correcting circuit 12 or not.

If the reception broadcasting wave is an RDS broadcasting wave, the processor fetches the PI data (step S44) and then checks to see if the taken PI data coincides with the PI data held in step S21 or not (step S45). If they coincide, step S32 follows and the audio muting is canceled (step S32) and the frequency of the presently received station is set as a new receiving frequency (step S33). Thus, the same PI station out of the same network station group can be received. If it is determined in step S40 that a received station doesn't exist, if it is decided in step S42 that the reception signal level Vₛ is less than the set level Vₜₕ, if it is decided in step S43 that the reception broadcasting wave is not an RDS broadcasting wave, or if it is decided in step S45 that the PI data are different, the processing routine is returned to step S35. In step S35, the receiving frequency is further increased by only one step and a searching process of the same PI station by a frequency sweeping process is repeated until it is determined in step S36 that the set frequency has been returned to the initial frequency.

If it is determined in step S36 that the set frequency has been returned to the initial frequency, that is, if the same PI station cannot be detected by the frequency sweeping process in the reception band, the processor reads out the original receiving frequency data held in step S21 (step S46). The frequency data which has been read out is supplied to the PLL circuit 7 (step S47) and the PLL timer is set (step S48). After the PLL timer has timed up (step S49), the audio muting is canceled (step S50). The frequency of the originally received station is set as a new receiving frequency (step S51). Thus, the received station has been returned to the originally received station.

As described above, in the second embodiment of the receiving frequency selecting method according to the invention, the PI data of the initially received station is previously held and in the case where the existence of a same network station cannot be detected by the network following function, if the existence of a received station whose reception signal level is equal to or higher than the set level and in which the reception PI data coincides with the holding PI data has been detected while executing a frequency sweeping operation, the frequency of such a receive d station is set as a new receiving frequency. Thus, even if a same network station cannot be detected, a broadcasting station of the same program can be automatically searched, so that the possibility that a broadcasting station of the same program can be received can be improved.

## Claims

1. A receiving frequency selecting method in an RDS receiver which can receive an RDS broadcasting wave on which a plurality of frequency data and program ID data of a same network station group are superimposed, the program ID data including PI data, in which a receiving frequency is switched from a current receiving frequency to a frequency of another same network station which is given by one of said plurality of frequency data, comprising:
a first step of holding the program ID data which is obtained from the broadcasting wave of the current receiving frequency in response to a command;
a second step of tuning the receiver to another frequency based on said plurality of frequency data; and detecting the existence of a received station;
a third step of taking in the program ID data obtained from the broadcasting wave of the received station detected in said second step;
a fourth step of setting a timer to time-out after a predetermined time has elapsed from a time point when the existence of the received station has been detected in the second step; and
a fifth step of comparing whether the program ID data obtained in said third step coincides with the program ID data held in the first step or not and setting the frequency of the presently received station as a new receiving frequency when said PI data coincides; **characterized by**
a step of determining when the same program ID has been taken in a plural number of times in the third step, wherein the fifth step of comparing is executed either when it has been determined that the same program ID data has been taken in a plural number of times in the third step, or that the predetermined time has elapsed, whichever occurs soonest.

2. A receiving frequency selecting method as claimed in claim 1, further comprising:
a step for detecting when the existence of the same network station has not been detected in said second step, whether or not a received station whose reception signal level is equal to or higher than a set level and in which the program ID data obtained from the received broadcasting wave of said received station coincides with the program ID data held in said first step exists by sweeping the receiving frequency, and setting the frequency of said received station as a new receiving frequency if the existence of said received station is detected.

3. A method according to claims 1 and 2 in combination wherein, in said first step of holding the program ID data, the frequency data which is obtained from the broadcasting wave of said current receiving frequency is also held, and wherein the method further includes a step in which when the existence of a received station cannot be detected in said step for detecting defined in claim 2, the receiving frequency is returned to the current receiving frequency which is given by the frequency data held in the first step.

## Patentansprüche

1. Ein Empfangsfrequenz-Auswahlverfahren in einem RDS-(Radiodatensystem)-Empfänger, der in der Lage ist, eine RDS Funkwelle zu empfangen, auf der eine Vielzahl von Frequenzdaten und Programm-ID-Daten der gleichen Sendemetzgruppe überlagert sind, wobei die Programm-ID-Daten PI-Daten beinhalten, in denen eine Empfangsfrequenz von einer laufenden Empfangsfrequenz auf eine Frequenz einer anderen Station des gleichen Netzes umgeschaltet wird, die durch eine der Vielzahl der Frequenzdaten gegeben ist, enthaltend:
Einen ersten Schritt zum Festhalten der Programm-ID-Daten, die aus der Senderwelle der augenblicklichen Empfangsfrequenz als Reaktion auf einen Befehl gewonnen werden;
einen zweiten Schritt zum Einregeln des Empfängers auf eine andere Frequenz aufgrund dieser Vielzahl von Frequenzdaten; und Erfassen der Existenz einer empfangenen Station;
einen dritten Schritt zum Aufnehmen der Programm-ID-Daten, die aus der Senderwelle der empfangenen Station gewonnen werden, die im zweiten Schritt erfasst wurde;
einen vierten Schritt zum Einstellen eines Zeitgebers, der einen Abschaltvorgang durchführt, nachdem eine vorbestimmte Zeitspanne seit einem Zeitpunkt verstrichen ist, zu dem die Existenz der empfangenen Station im zweiten Schritt erfasst worden ist;
einen fünften Schritt zum Vergleichen, ob die im dritten Schritt gewonnenen Programm-ID-Daten mit den im ersten Schritt festgehaltenen Programm-ID-Daten übereinstimmen oder nicht, und Einstellen der Frequenz der augenblicklich empfangenen Station als neue Empfangsfrequenz, wenn die PI-Daten übereinstimmen; **gekennzeichnet durch**
einen Schritt des Feststellens, wann dieselbe Programm-ID eine Vielzahl von Malen aufgenommen worden ist im dritten Schritt, wobei der fünfte Schritt des Vergleichens durchgeführt wird, entweder dann, wenn festgestellt worden ist, dass dieselben Programm-ID-Daten im dritten Schritt eine Vielzahl von Malen aufgenommen worden sind, oder dass die vorbestimmte Zeitdauer verstrichen ist, was immer zuerst passiert.

2. Eine Empfangsfrequenzauswahlmethode gemäß Anspruch 1, die ferner beinhaltet:
Einen Schritt zum Feststellen durch Wobbeln der Empfangsfrequenz - wenn die Existenz der gleichen Netzstation im zweiten Schritt nicht erfasst wurde - ob eine Empfangsstation, deren Empfangssignalhöhe gleich oder höher als eine eingestellte Höhe ist und in der die von der empfangenen Senderwelle der empfangenen Station gewonnenen Programm-ID-Daten mit den im ersten Schritt festgehaltenen Programm-ID-Daten übereinstimmen, existiert oder nicht, und Einstellen der Frequenz der empfangenen Station als neue Empfangsfrequenz, wenn die Existenz der empfangenen Station erfasst wird.

3. Verfahren gemäß Anspruch 1 oder 2 in Kombination, wobei in dem ersten Schritt des Haltens der Programm-ID-Daten, die Frequenzdaten, die von der Senderwelle der augenblicklichen empfangenen Frequenz erhalten werden, ebenfalls gehalten werden, und wobei das Verfahren weiterhin einen Schritt umfasst, in welchem, wenn die Existenz einer empfangenen Station nicht erfasst werden kann, in dem Schritt zum Erfassen, wie er in Anspruch 2 festgelegt ist, die Empfangsfrequenz zurückgesetzt wird auf die augenblickliche Empfangsfrequenz, welche gegeben ist durch die Frequenzdaten, die im ersten Schritt gehalten werden.

## Revendications

1. Procédé de sélection de fréquence de réception dans un récepteur RDS qui peut recevoir une onde de radiodiffusion RDS sur laquelle sont superposées une pluralité de données de fréquence et de données d'identification de programme d'un groupe de stations d'un même réseau, les données d'identification de programme comprenant des données PI dans lesquelles une fréquence de réception est commutée depuis une fréquence actuelle de réception vers une fréquence d'une autre station du même réseau qui est donnée par une parmi ladite pluralité de données de fréquence, comprenant :
une première étape consistant à conserver les données d'identification de programme qui sont obtenues à partir de l'onde de radiodiffusion de la fréquence actuelle de réception, en réponse à une commande ;
Une deuxième étape consistant à accorder le récepteur sur une autre fréquence en se basant sur ladite pluralité de données de fréquence, et à détecter l'existence d'une station reçue ;
Une troisième étape consistant à prendre les données d'identification de programme obtenues à partir de l'onde de radiodiffusion de la station reçue détectée dans ladite deuxième étape ;
Une quatrième étape consistant à activer une minuterie pour expirer après qu'une durée prédéterminée s'est écoulée depuis un instant de temps où l'existence de la station reçue a été détectée dans la deuxième étape ; et
une cinquième étape consistant à comparer, si les données d'identification de programme obtenues à ladite troisième étape coïncident ou non avec les données d'identification de programme conservées à la première étape et à fixer la fréquence de la station actuellement reçue comme nouvelle fréquence de réception quand lesdites données PI coïncident ;
**caractérisé par**
une étape consistant à déterminer l'étape qui se produit le plus tôt, quand les mêmes données d'identification de programme ont été recueillies plusieurs fois à la troisième étape, dans laquelle la cinquième étape consistant à comparer est exécutée, soit quand on a déterminé que les mêmes données d'identification de programme ont été recueillies plusieurs fois à la troisième étape, soit que le temps prédéterminé est écoulé.

2. Procédé de sélection de fréquence de réception selon la revendication 1, comprenant en outre :
une étape pour détecter, quand l'existence de la station du même réseau n'a pas été détectée à ladite deuxième étape, s'il existe ou non une station reçue dont le niveau de signal de réception est égal ou supérieur à un niveau prédéterminé et dans laquelle les données d'identification de programme obtenues à partir de l'onde reçue de radiodiffusion de ladite station reçue coïncident avec les données d'identification de programme conservées a ladite première étape, en balayant la fréquence de réception, et pour fixer la fréquence de ladite station comme nouvelle fréquence de réception si l'existence de ladite station reçue est détectée.,

3. Procédé selon les revendications 1 et 2, en combinaison, dans lequel à ladite première étape consistant à conserver les données d'identification de programme, les données de fréquence qui sont obtenues à partir de l'onde de radiodiffusion de ladite fréquence actuelle de réception sont aussi conservées, et
comprenant en outre une étape dans laquelle, quand l'existence d'une station reçue ne peut pas être détectée à ladite étape pour détecter définie dans la revendication 2, la fréquence actuelle de réception qui est donnée par les données de fréquence conservées à la première étape.
